# EUROPEAN PATENT APPLICATION

(11) **EP 4 753 148 A1**
(43) Date of publication of application: **03.06.2026**
(21) Application number: 23952210.5
(22) Date of filing: 13.09.2023
(51) Int. Cl.: H03H 19/00

(54) **BANDPASS FILTER**

(71) Applicant: MITSUBISHI ELECTRIC CORPORATION, Chiyoda-ku Tokyo 100-8310 (JP)
(72) Inventor: YAMASHITA, Shimpei, Tokyo 100-8310 (JP); HIRAI, Akihito, Tokyo 100-8310 (JP)
(74) Representative: Pfenning, Meinig & Partner mbB
(86) International application number: PCT/JP2023/033274
(87) International publication number: WO 2025/057316

(57) **Abstract**

A bandpass filter (1) includes: an input terminal (2A) to receive an input of a high frequency signal; an output terminal (2B) to output an output signal; differential switches (4 to 9) provided between the input terminal (2A) and the output terminal (2B), connected in a tournament pattern with a plurality of switches (10 to 21) controlled according to a clock signal, and each including two switches; and capacitances (22 to 25) each including one end connected to a connection point between the switches of the differential switches, and another end grounded.

## Description

### TECHNICAL FIELD

The present disclosure relates to a bandpass filter.

### BACKGROUND ART

Bandpass filters for eliminating interference waves or unnecessary waves are used for wireless communication. There is a technique that relates to a bandpass filter circuit that allows only a signal of a desired frequency component to pass by changing a center frequency of a use frequency range or an attenuation amount to a desired value.

A bandpass filter includes a switch that is connected between an input and an output, and switches an input signal voltage at a system clock frequency, a switched capacitor that is connected between a switch and a ground potential, a plurality of sample hold capacitors that are connected between the output and the ground potential, and a plurality of sample hold switches that are connected between the output and the ground potential, and are connected in series to the sample hold capacitors. The sample hold switch is sequentially turned on one by one at a sampling clock frequency, holds a signal voltage appearing at a sample time in the sample hold capacitor, and cyclically and sequentially switches the sample hold switches.

On the other hand, for example, Non-Patent Literature 1 describes a bandpass filter that can increase a duty ratio of a sampling clock signal compared to a conventional circuit configuration by connecting two sample hold switches in series, and drives the sample hold switches according to the sampling clock signal whose duty ratio is 50%. It is difficult to generate a sampling clock signal of a low duty ratio in a high frequency band, so that improvement of pass characteristics in the high frequency band can be expected by the configuration described in Non-Patent Literature 1.

### CITATION LIST

### PATENT LITERATURE

Non-Patent Literature 1: "A Millimeter-Wave Front-End for FD/FDD Transceivers Featuring an Embedded PA and an N-Path Filter Based Circulator Receiver," M. Pashaeifar, L. C. N. De Vreede and M. S. Alavi, 2022 IEEE Radio Frequency Integrated Circuits Symposium (RFIC), Denver, CO, USA, 2022, pp. 11-14

### SUMMARY OF INVENTION

### TECHNICAL PROBLEM

However, according to the conventional technique described in Non-Patent Literature 1, a signal path to a capacitor with which a signal voltage is charged is controlled by the two switches to turn on or off, and the number of switches per signal path is two. Hence, there has been a problem that a parasitic capacitance deriving from switches seen from a clock signal source becomes great, and a clock signal becomes dull.

When the clock signal becomes dull, an on-time of the switch changes, and therefore a voltage to be charged to a capacitor changes and characteristics deterioration such as an increase in pass loss occurs.

The present disclosure solves the above problem, and an object of the present disclosure is to provide a bandpass filter that can suppress dullness of a clock signal deriving from a switch for switching a signal path.

### SOLUTION TO PROBLEM

A bandpass filter according to the present disclosure includes: an input terminal to receive an input of a high frequency signal; an output terminal to output an output signal; a plurality of differential switches provided between the input terminal and the output terminal, in which a plurality of switches respectively controlled according to clock signals is connected in a tournament pattern, each of the plurality of differential switches including two switches; and a plurality of capacitors each including one end connected to a connection point between switches respectively included in differential switches among the plurality of differential switches, and another end grounded.

### ADVANTAGEOUS EFFECTS OF INVENTION

According to the present disclosure, the bandpass filter includes: a plurality of differential switches connected in a tournament pattern with a plurality of switches controlled according to a clock signal, and each including two switches; and a plurality of capacitors each including one end connected to a connection point between the switches of the differential switches, and another end grounded. Consequently, the bandpass filter according to the present disclosure includes one fewer switches to be driven according to a clock signal of each phase than those of the bandpass filter described in Non-Patent Literature 1. That is, the bandpass filter according to the present disclosure includes the one fewer switches seen from a clock signal source, so that it is possible to suppress dullness of a clock signal deriving from a switch for switching a signal path.

### BRIEF DESCRIPTION OF DRAWINGS

FIG. 1 is a circuit diagram illustrating a configuration example of a bandpass filter according to Embodiment 1.
FIG. 2 is a diagram illustrating a clock signal source.
FIG. 3 is a waveform diagram illustrating the waveforms of clock signals of the bandpass filter according to Embodiment 1.
FIG. 4 is a circuit diagram illustrating a configuration example of a bandpass filter according to Embodiment 2.
FIG. 5 is a waveform diagram illustrating the waveforms of the clock signals of the bandpass filter according to Embodiment 2.

### DESCRIPTION OF EMBODIMENTS

### Embodiment 1.

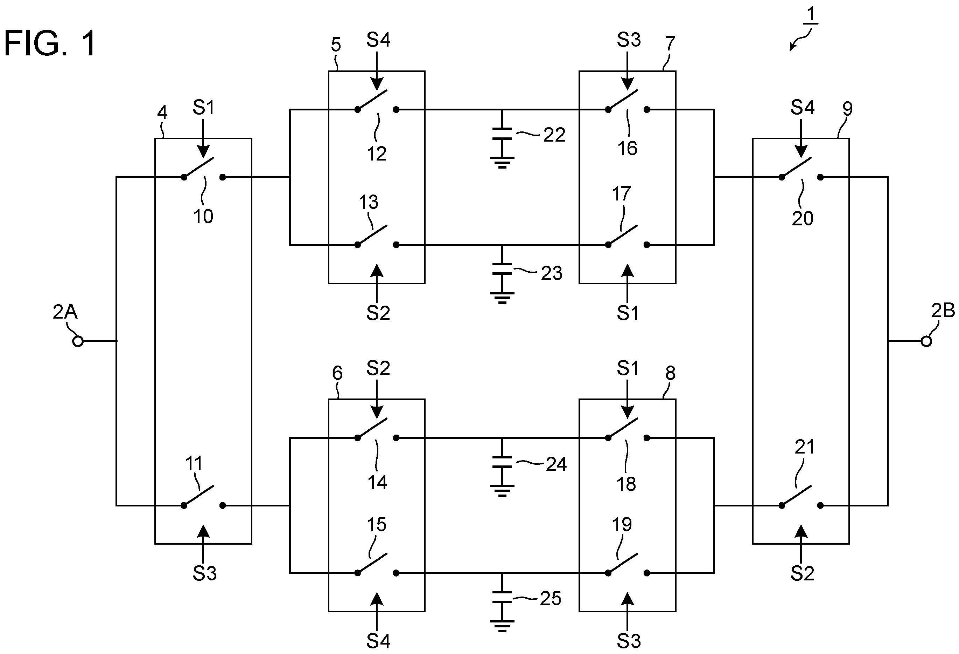

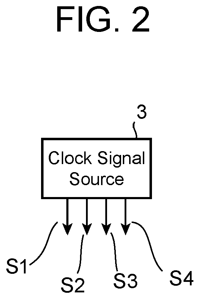

FIG. 1 is a circuit diagram illustrating a configuration example of a bandpass filter 1 according to Embodiment 1. Furthermore, FIG. 2 is a diagram illustrating a clock signal source 3. In FIG. 1, the bandpass filter 1 is an N-path filter that can suppress deterioration of an attenuation amount of an unnecessary wave, and suppress attenuation of a gain of a desired wave. The bandpass filter 1 is a filter that is controlled according to clock signals S1, S2, S3, and S4 generated by the clock signal source 3 illustrated in FIG. 2, and includes an input terminal 2A, an output terminal 2B, differential switches 4 to 9, and capacitors 22 to 25.

In a case where a clock period is T_{LO}, the clock signal source 3 generates the four clock signals S1, S2, S3, and S4 whose duty ratios are 50% and whose phases are delayed by 90 degrees from each other. The clock signal S1 is a first clock signal whose phase is 0 degree. The clock signal S2 is a second clock signal whose phase is 90 degrees. The clock signal S3 is a third clock signal whose phase is 180 degrees. The clock signal S4 is a fourth clock signal whose phase is 270 degrees. Furthermore, the clock signal source 3 may be configured with a differential amplifier circuit.

Note that, as long as the bandpass filter operates as a desired filter, the duty ratio may not be 50%, and other waveforms such as a sine wave having periodicity may be used.

The differential switches 4 to 9 are configured to be provided between the input terminal 2A and the output terminal 2B, and connected in a tournament pattern with switches 10 to 21 controlled according to clock signals generated by the clock signal source 3. Each differential switch includes two switches. For example, switches included in one differential switch are controlled according to clock signals whose phases differ by 180 degrees from each other. Each switch outputs a signal when a clock signal is at a high level.

The differential switch 4 is a first differential switch including a switch 10 and a switch 11 connected to the input terminal 2A. The switch 10 is a first switch that receives an input of one of two signals split from the input terminal 2A, and is controlled according to the clock signal S1. The switch 11 is a second switch that receives an input of the other one of the two signals split from the input terminal 2A, and is controlled according to the clock signal S3.

The differential switch 5 is a second differential switch including a switch 12 and a switch 13 connected to the switch 10 constituting the differential switch 4. The switch 12 is a third switch that receives an input of a signal from the switch 10, and is controlled according to the clock signal S4. The switch 13 is a fourth switch that receives an input of the signal from the switch 10, and is controlled according to the clock signal S2.

The differential switch 6 is a third differential switch including a switch 14 and a switch 15 connected to the switch 11 constituting the differential switch 4. The switch 14 is a fifth switch that receives an input of a signal from the switch 11, and is controlled according to the clock signal S2. The switch 15 is a sixth switch that receives an input of a signal from the switch 11, and is controlled according to the clock signal S4.

The differential switch 7 is a fourth differential switch including a switch 16 connected to the switch 12 constituting the differential switch 5, and a switch 17 connected to the switch 13 constituting the differential switch 5. The switch 16 is a seventh switch that receives an input of a signal from the switch 12, and is controlled according to the clock signal S3. The switch 17 is an eighth switch that receives an input of a signal from the switch 13, and is controlled according to the clock signal S1.

The differential switch 8 is a fifth differential switch including a switch 18 connected to the switch 14 constituting the differential switch 6, and a switch 19 connected to the switch 15 constituting the differential switch 6. The switch 18 is a ninth switch that receives an input of a signal from the switch 14, and is controlled according to the clock signal S1. The switch 19 is a tenth switch that receives an input of a signal from the switch 15, and is controlled according to the clock signal S3.

The differential switch 9 is a sixth differential switch including a switch 20 connected to the switch 16 and the switch 17 constituting the differential switch 7, and a switch 21 connected to the switch 18 and the switch 19 constituting the differential switch 8.

The switch 20 is an eleventh switch that receives an input of a signal from one or both of the switch 16 and the switch 17, and is controlled according to the clock signal S4.

The switch 21 is a twelfth switch that receives an input of a signal from one or both of the switch 18 and the switch 19, and is controlled according to the clock signal S2.

An output signal output from the output terminal 2B is a signal obtained by synthesizing outputs of the switch 20 and the switch 21.

The capacitors 22 to 25 are a plurality of capacitors each including one end connected to a connection point between the switches of the differential switches, and another end grounded. The capacitor 22 is a first capacitor having the one end connected to a connection point between the switch 12 of the differential switch 5 and the switch 16 of the differential switch 7, and the other end grounded. The capacitor 23 is a second capacitor having the one end connected to a connection point between the switch 13 of the differential switch 5 and the switch 17 of the differential switch 7, and the other end grounded. The capacitor 24 is a third capacitor having the one end connected to a connection point between the switch 14 of the differential switch 6 and the switch 18 of the differential switch 8, and the other end grounded. The capacitor 25 is a fourth capacitor having the one end connected to a connection point between the switch 15 of the differential switch 6 and the switch 19 of the differential switch 8, and the other end grounded.

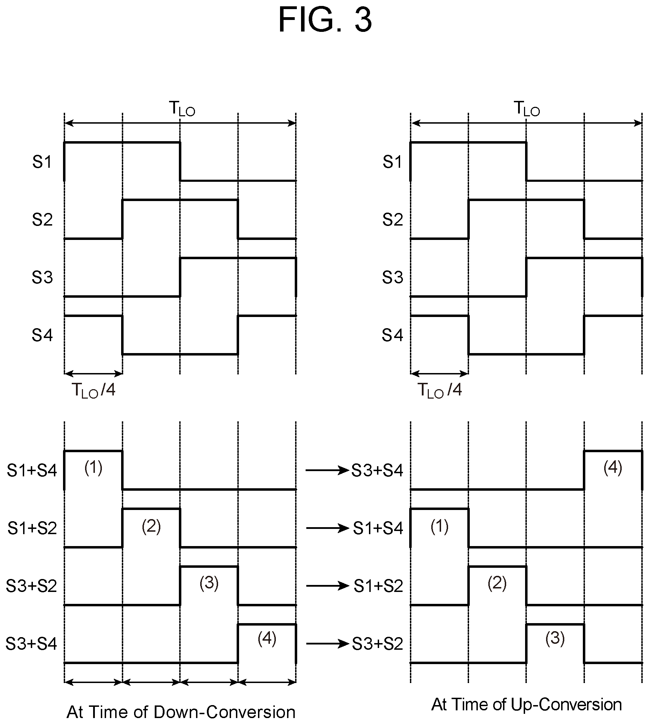

FIG. 3 is a waveform diagram illustrating the waveforms of the clock signals S1, S2, S3, and S4 of the bandpass filter 1. Upper left and upper right diagrams in FIG. 3 illustrate the waveforms of the clock signals S1, S2, S3, and S4 to be sequentially output at the cycle T_{LO} from the clock signal source 3. The clock signals S1, S2, S3, and S4 of four phases are signals that are shifted by T_{LO}/4 from each other. A lower left diagram in FIG. 3 illustrates the waveform of a clock signal at a time of down-conversion of the bandpass filter 1. A lower right diagram in FIG. 3 illustrates the waveform of a clock signal at a time of up-conversion of the bandpass filter 1.

A period in which the clock signal S1 and the clock signal S4 are turned on (high level) in lower left and lower right diagrams in FIG. 3 is defined as a zone (1) illustrated in the lower left and lower right diagrams in FIG. 3.

A period in which the clock signal S1 and the clock signal S2 are turned on in the lower left and lower right diagrams in FIG. 3 is defined as a zone (2) illustrated in the lower left and lower right diagrams in FIG. 3.

A period in which the clock signal S2 and the clock signal S3 are turned on in the lower left and lower right diagrams in FIG. 3 is defined as a zone (3) illustrated in the lower left and lower right diagrams in FIG. 3.

A period in which the clock signal S3 and the clock signal S4 are turned on in the upper left and upper right diagrams in FIG. 3 is defined as a zone (4) illustrated in the lower left and lower right diagrams in FIG. 3.

As illustrated in the lower left diagram in FIG. 3, in the bandpass filter 1, the switch 10 is turned on according to the clock signal S1 only in the zone (1), and the switch 12 is turned on according to the clock signal S4 only in the zone (1). In this case, a signal input from the input terminal 2A is down-converted at the clock frequency, and the signal voltage is charged to the capacitor 22.

As illustrated in the lower right diagram in FIG. 3, in the bandpass filter 1, the switch 16 is turned on according to the clock signal S3 only in the zone (4), and the switch 20 is turned on according to the clock signal S4 only in the zone (4). In this case, a signal charged with a voltage in the zone (1) is up-converted.

Similarly, in the bandpass filter 1, the switch 10 is turned on according to the clock signal S1 only in the zone (2), and the switch 13 is turned on according to the clock signal S2 only in the zone (2). In this case, the signal input from the input terminal 2A is down-converted at the clock frequency, and the signal voltage is charged to the capacitor 23.

As illustrated in the lower right diagram in FIG. 3, in the bandpass filter 1, the switch 17 is turned on according to the clock signal S1 only in the zone (1), and the switch 20 is turned on according to the clock signal S4 only in the zone (1). In this case, a signal charged with a voltage in the zone (2) is up-converted.

Similarly, in the bandpass filter 1, the switch 11 is turned on according to the clock signal S3 only in the zone (3), and the switch 14 is turned on according to the clock signal S2 only in the zone (3). In this case, the signal input from the input terminal 2A is down-converted at the clock frequency, and the signal voltage is charged to the capacitor 24.

As illustrated in the lower right diagram in FIG. 3, in the bandpass filter 1, the switch 18 is turned on according to the clock signal S1 only in the zone (2), and the switch 21 is turned on according to the clock signal S2 only in the zone (2). In this case, a signal charged with a voltage in the zone (3) is up-converted.

Similarly, in the bandpass filter 1, the switch 11 is turned on according to the clock signal S3 only in the zone (4), and the switch 15 is turned on according to the clock signal S4 only in the zone (4). In this case, the signal input from the input terminal 2A is down-converted at the clock frequency, and the signal voltage is charged to the capacitor 25.

As illustrated in the lower right diagram in FIG. 3, in the bandpass filter 1, the switch 19 is turned on according to the clock signal S3 only in the zone (3), and the switch 21 is turned on according to the clock signal S2 only in the zone (3). In this case, a signal charged with a voltage in the zone (4) is up-converted.

By performing an operation in a signal path for charging the capacitors 22, 23, 24, and 25 with the signals voltages at a designated timing in the bandpass filter 1, an up-converted signal is added, and the added signal is output from the output terminal 2B.

The above operation is to generate clock signals of four phases by calculating a logical product of the clock signals whose duty ratios are 50% and whose phases differ by 90 degrees from each other, and consequently achieves bandpass filter characteristics of a narrow band whose center is a clock signal frequency.

In this regard, since the signals down-converted in the zones (1), (2), (3), and (4) are output in the zones (4), (1), (2), and (3), the phase of the output signal delays by 270° from the input signal.

Note that, as long as the phase differences between clock signals match in zones at a time of down-conversion and zones at a time of up-conversion in all signal paths, and the numbers of switches to be driven according to clock signals match, driving timings of the above-described switches may be different.

For example, in the bandpass filter 1, phase differences between clock signals at the time of down-conversion in the zone (1) and at the time of up-conversion in the zone (4) are 180 degrees and match.

Since the number of switches to be driven according to the clock signals are two of the switch 10 and the switch 12 at the time of down-conversion in the zone (1), and are two of the switch 16 and the switch 20 at the time of up-conversion in the zone (1), the numbers of switches to be driven in these zones match.

Note that, in a case where the numbers of switches to be driven according to clock signals do not match, the degree of dullness of a clock waveform differs, and therefore high frequency characteristics deteriorate.

In the bandpass filter 1, each differential switch includes two switches, and the capacitors 22 to 25 to be charged with signal voltages at the time of down-conversion are connected to connection points between the switches of the differential switches. Consequently, the bandpass filter 1 includes one fewer switches to be driven according to a clock signal of each phase than those of the bandpass filter described in Non-Patent Literature 1. That is, the bandpass filter 1 includes the one fewer switches seen from the clock signal source 3, so that a parasitic capacitance deriving from the switches is reduced by 25%, and, a frequency at which dullness of the clock waveform is produced improves, so that the bandpass filter 1 can operate at a high frequency.

As described above, the bandpass filter 1 according to Embodiment 1 includes the input terminal 2A that receives an input of a high frequency signal, the output terminal 2B that outputs an output signal, the differential switches 4 to 9 that are provided between the input terminal 2A and the output terminal 2B, connected in a tournament pattern with the plurality of switches 10 to 21 controlled according to clock signals, and each include two switches, and the capacitors 22 to 25 that each include the one end connected to a connection point between the switches of the differential switches, and the other end grounded. Consequently, the bandpass filter 1 includes one fewer switches to be driven according to a clock signal of each phase than those of the bandpass filter described in Non-Patent Literature 1. That is, the bandpass filter 1 includes the one fewer switches seen from the clock signal source 3, so that it is possible to suppress dullness of a clock signal deriving from a switch for switching a signal path.

The bandpass filter 1 according to Embodiment 1 is controlled according to, for example, the clock signal S1, the clock signal S2, the clock signal S3, and the clock signal S4 whose phases differ by 90 degrees from each other in order and whose duty ratios are 50%. The bandpass filter 1 includes the differential switch 4 that includes the switch 10 and the switch 11 connected to the input terminal 2A, the switch 10 being controlled according to the clock signal S1, and the switch 11 being controlled according to the clock signal S3, the differential switch 5 that includes the switch 12 and the switch 13 connected to the switch 10, the switch 12 being controlled according to the clock signal S4, and the switch 13 being controlled according to the clock signal S2, the differential switch 6 that includes the switch 14 and the switch 15 connected to the switch 11, the switch 14 being controlled according to the clock signal S2, and the switch 15 being controlled according to the clock signal S4, the differential switch 7 that includes the switch 16 connected to the switch 12 and controlled according to the clock signal S3, and the switch 17 connected to the switch 13 and controlled according to the clock signal S1, the differential switch 8 that includes the switch 18 connected to the switch 14 and controlled according to the clock signal S1, and the switch 19 connected to the switch 15 and controlled according to the clock signal S3, and the differential switch 9 that includes the capacitor 22 including the one end connected to a connection point between the switch 12 and the switch 16, and the other end grounded, the capacitor 23 including the one end connected to a connection point between the switch 13 and the switch 17, and the other end grounded, the capacitor 24 including the one end connected to a connection point between the switch 14 and the switch 18, and the other end grounded, the capacitor 25 including the one end connected to a connection point between the switch 15 and the switch 19, and the other end grounded, the switch 20 connected to the switch 16 and the switch 17 and controlled according to the clock signal S4, and the switch 21 connected to the switch 18 and the switch 19 and controlled according to the clock signal S2. An output signal output from the output terminal 2B is a signal obtained by synthesizing outputs of the switch 20 and the switch 21. With this configuration, the number of switches seen from the clock signal source 3 can be reduced by one, so that the bandpass filter 1 can suppress dullness of a clock signal deriving from a switch for switching a signal path.

### Embodiment 2.

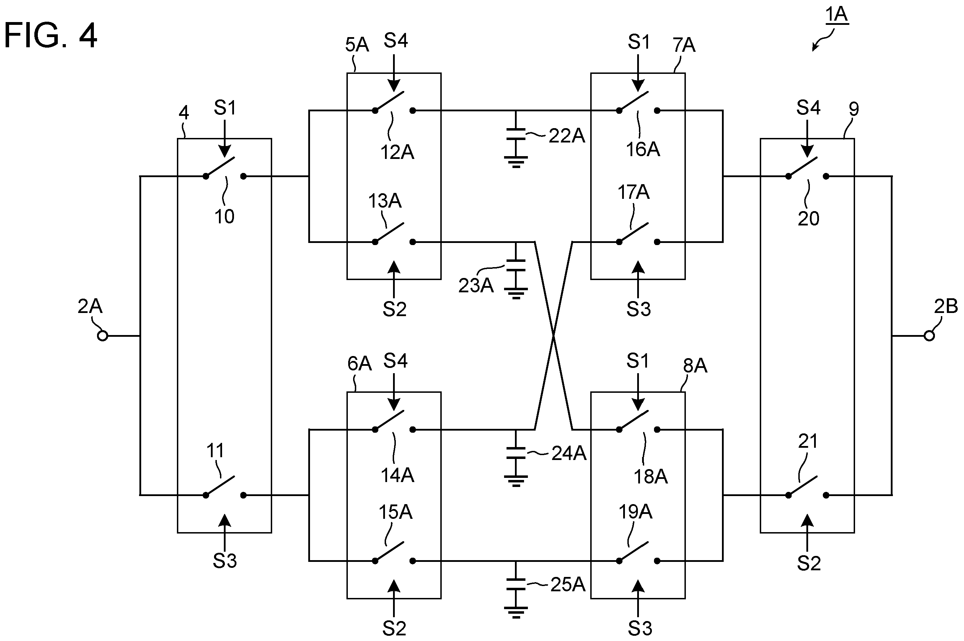

FIG. 4 is a circuit diagram illustrating a configuration example of a bandpass filter 1A according to Embodiment 2. In FIG. 4, the bandpass filter 1A is a filter that is called an N-path filter and can suppress deterioration of an attenuation amount of an unnecessary wave, and suppress attenuation of a gain of a desired wave. The bandpass filter 1A is a filter that is controlled according to the clock signals S1, S2, S3, and S4 generated by the clock signal source 3 illustrated in FIG. 2, and includes the input terminal 2A, the output terminal 2B, differential switches 4, 5A, 6A, 7A, 8A, and 9, and the capacitors 22 to 25.

In a case where the clock period is T_{LO}, the clock signal source 3 generates the four clock signals S1, S2, S3, and S4 whose duty ratios are 50% and whose phases are delayed by 90 degrees from each other similarly to FIG. 1. The clock signal S1 is the first clock signal whose phase is 0 degree. The clock signal S2 is the second clock signal whose phase is 90 degrees. The clock signal S3 is the third clock signal whose phase is 180 degrees. The clock signal S4 is the fourth clock signal whose phase is 270 degrees. Furthermore, the clock signal source 3 may be configured as a differential amplifier. Note that, as long as the bandpass filter operates as a desired filter, the duty ratio may not be 50%, and other waveforms such as a sine wave having periodicity may be used.

The differential switches 4, 5A, 6A, 7A, 8A, and 9 are configured to be provided between the input terminal 2A and the output terminal 2B, and connected in a tournament pattern with a plurality of switches controlled according to clock signals generated by the clock signal source 3. Each differential switch includes two switches. For example, switches included in one differential switch are controlled according to two clock signals whose phases differ by 180 degrees. Each switch outputs a signal when a clock signal is at a high level.

The differential switch 4 is the first differential switch including the switch 10 and the switch 11 connected to the input terminal 2A similarly to the bandpass filter 1. The switch 10 is the first switch that receives an input of one of two signals split from the input terminal 2A, and is controlled according to the clock signal S1. The switch 11 is the second switch that receives an input of the other one of the two signals split from the input terminal 2A, and is controlled according to the clock signal S3.

The differential switch 5A is a second differential switch including a switch 12A and a switch 13A connected to the switch 10 constituting the differential switch 4. The switch 12A is a third switch that receives an input of a signal from the switch 10, and is controlled according to the clock signal S4. The switch 13A is a fourth switch that receives an input of the signal from the switch 10, and is controlled according to the clock signal S2.

The differential switch 6A is a third differential switch including a switch 14A and a switch 15A connected to the switch 11 constituting the differential switch 4. The switch 14A is a fifth switch that receives an input of a signal from the switch 11, and is controlled according to the clock signal S4. The switch 15A is a sixth switch that receives an input of the signal from the switch 11, and is controlled according to the clock signal S2.

The differential switch 7A is a fourth differential switch including a switch 16A connected to the switch 12A constituting the differential switch 5A, and a switch 17A connected to the switch 14A constituting the differential switch 6A. The switch 16A is a seventh switch that receives an input of a signal from the switch 12A, and is controlled according to the clock signal S1. The switch 17A is an eighth switch that receives an input of the signal from the switch 14A, and is controlled according to the clock signal S3.

The differential switch 8A is a fifth differential switch including a switch 18A connected to the switch 13A constituting the differential switch 5A, and a switch 19A connected to the switch 15A constituting the differential switch 6A. The switch 18A is a ninth switch that receives an input of a signal from the switch 13A, and is controlled according to the clock signal S1. The switch 19A is a tenth switch that receives an input of the signal from the switch 15A, and is controlled according to the clock signal S3.

The differential switch 9 is the sixth differential switch including the switch 20 connected to the switch 16A and the switch 17A constituting the differential switch 7A, and the switch 21 connected to the switch 18A and the switch 19A constituting the differential switch 8A.

The switch 20 is the eleventh switch that receives an input of a signal from one or both of the switch 16A and the switch 17A, and is controlled according to the clock signal S4.

The switch 21 is the twelfth switch that receives an input of a signal from one or both of the switch 18A and the switch 19A, and is controlled according to the clock signal S2.

An output signal output from the output terminal 2B is a signal obtained by synthesizing outputs of the switch 20 and the switch 21.

The capacitors 22A, 23A, 24A, and 25A are a plurality of capacitors each including one end connected to a connection point between the switches of the differential switches, and another end grounded. The capacitor 22A is a first capacitor having the one end connected to a connection point between the switch 12A of the differential switch 5A and the switch 16A of the differential switch 7A, and the other end grounded. The capacitor 23A is a second capacitor having the one end connected to a connection point between the switch 13A of the differential switch 5A and the switch 18A of the differential switch 8A, and the other end grounded. The capacitor 24A is a third capacitor having the one end connected to a connection point between the switch 14A of the differential switch 6A and the switch 17A of the differential switch 7A, and the other end grounded. The capacitor 25A is a fourth capacitor having the one end connected to a connection point between the switch 15A of the differential switch 6A and the switch 19A of the differential switch 8A, and the other end grounded.

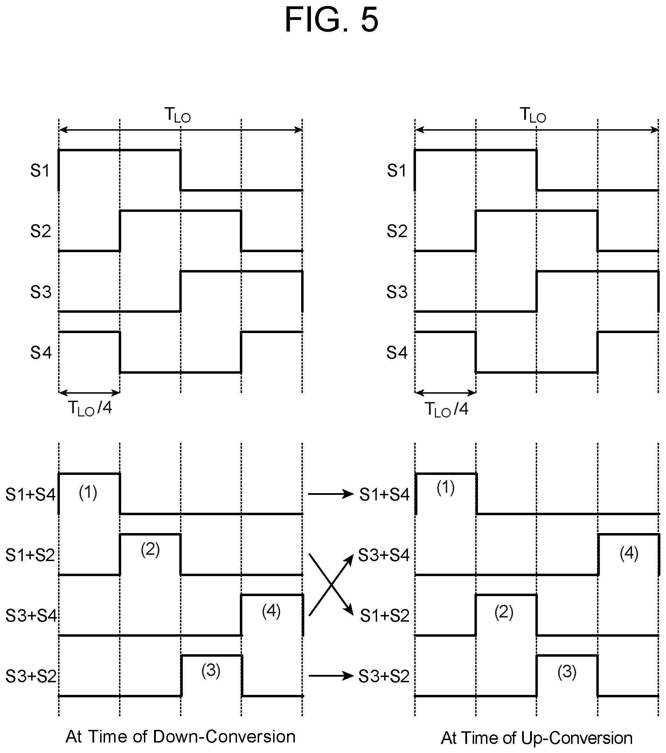

FIG. 5 is a waveform diagram illustrating the waveforms of the clock signals S1, S2, S3, and S4 of the bandpass filter 1A. Upper left and upper right diagrams in FIG. 5 illustrate the waveforms of the clock signals S1, S2, S3, and S4 to be sequentially output at the cycle T_{LO} from the clock signal source 3. The clock signals S1, S2, S3, and S4 of the four phases are signals that are shifted by T_{LO}/4 from each other. A lower left diagram in FIG. 5 illustrates the waveform of a clock signal at a time of down-conversion of the bandpass filter 1A. A lower right diagram in FIG. 5 illustrates the waveform of a clock signal at a time of up-conversion of the bandpass filter 1A.

A period in which the clock signal S1 and the clock signal S4 are turned on (high level) in lower left and lower right diagrams in FIG. 5 is defined as a zone (1) illustrated in the lower left and lower right diagrams in FIG. 5.

A period in which the clock signal S1 and the clock signal S2 are turned on in the lower left and lower right diagrams in FIG. 5 is defined as a zone (2) illustrated in the lower left and lower right diagrams in FIG. 5.

A period in which the clock signal S2 and the clock signal S3 are turned on in the lower left and lower right diagrams in FIG. 5 is defined as a zone (3) illustrated in the lower left and lower right diagrams in FIG. 5.

A period in which the clock signal S3 and the clock signal S4 are turned on in the lower left and lower right diagrams in FIG. 5 is defined as a zone (4) illustrated in the lower left and lower right diagrams in FIG. 5.

As illustrated in the lower left diagram in FIG. 5, in the bandpass filter 1A, the switch 10 is turned on according to the clock signal S1 only in the zone (1), and the switch 12A is turned on according to the clock signal S4 only in the zone (1). In this case, the signal input from the input terminal 2A is down-converted at the clock frequency, and the signal voltage is charged to the capacitor 22A.

As illustrated in the lower right diagram in FIG. 5, in the bandpass filter 1A, the switch 16A is turned on according to the clock signal S1 only in the zone (1), and the switch 20 is turned on according to the clock signal S4 only in the zone (1). In this case, a signal charged with a voltage in the zone (1) is up-converted.

Similarly, in the bandpass filter 1A, the switch 10 is turned on according to the clock signal S1 only in the zone (2), and the switch 13A is turned on according to the clock signal S2 only in the zone (2). In this case, the signal input from the input terminal 2A is down-converted at the clock frequency, and the signal voltage is charged to the capacitor 23A.

As illustrated in the lower right diagram in FIG. 5, in the bandpass filter 1A, the switch 18A is turned on according to the clock signal S1 only in the zone (2), and the switch 21 is turned on according to the clock signal S2 only in the zone (2). In this case, a signal charged with a voltage in the zone (2) is up-converted.

Similarly, in the bandpass filter 1A, the switch 11 is turned on according to the clock signal S3 only in the zone (4), and the switch 14A is turned on according to the clock signal S4 only in the zone (4). In this case, the signal input from the input terminal 2A is down-converted at the clock frequency, and the signal voltage is charged to the capacitor 24A.

As illustrated in the lower right diagram in FIG. 5, in the bandpass filter 1A, the switch 17A is turned on according to the clock signal S3 only in the zone (4), and the switch 20 is turned on according to the clock signal S4 only in the zone (4). In this case, a signal charged with a voltage in the zone (4) is up-converted.

Similarly, in the bandpass filter 1A, the switch 11 is turned on according to the clock signal S3 only in the zone (3), and the switch 15A is turned on according to the clock signal S2 only in the zone (3). In this case, the signal input from the input terminal 2A is down-converted at the clock frequency, and the signal voltage is charged to the capacitor 25A.

As illustrated in the lower right diagram in FIG. 5, in the bandpass filter 1A, the switch 19A is turned on according to the clock signal S3 only in the zone (3), and the switch 21 is turned on according to the clock signal S2 only in the zone (3). In this case, a signal charged with a voltage in the zone (3) is up-converted.

By performing an operation in a signal path for charging the capacitors 22A, 23A, 24A, and 25A with the signals voltages at a designated timing in the bandpass filter 1A, an up-converted signal is added, and the added signal is output from the output terminal 2B. The above operation is to generate clock signals of four phases by calculating a logical product of the clock signals whose duty ratios are 50% and whose phases differ by 90 degrees from each other, and consequently achieves bandpass filter characteristics of a narrow band whose center is a clock signal frequency.

In this regard, the signals down-converted in the zones (1), (2), (3), and (4) are output in the zones (1), (2), (3), and (4), so that it is possible to suppress unnecessary phase rotation unlike the bandpass filter 1.

Note that, as long as the phase differences between clock signals match in zones at a time of down-conversion and zones at a time of up-conversion in all signal paths, and the numbers of switches to be driven according to clock signals match, driving timings of the above-described switches may be different.

For example, in the bandpass filter 1A, phase differences between clock signals at the time of down-conversion in the zone (1) and at the time of up-conversion in the zone (1) are 180 degrees and match.

Since the number of switches to be driven according to the clock signals are two of the switch 10 and the switch 12A at the time of down-conversion in the zone (1), and are two of the switch 16A and the switch 20A at the time of up-conversion in the zone (1), the numbers of switches to be driven in these zones match.

Note that, in a case where the numbers of switches to be driven according to clock signals do not match, the degree of dullness of a clock waveform differs, and therefore high frequency characteristics deteriorate.

In the bandpass filter 1A, each differential switch includes two switches, and the capacitors 22A, 23A, 24A, and 25A to be charged with signal voltages at the time of down-conversion are connected to a connection point between the switches of the differential switches. Consequently, the bandpass filter 1A includes one fewer switches to be driven according to a clock signal of each phase than those of the bandpass filter described in Non-Patent Literature 1. That is, the bandpass filter 1A includes the one fewer switches seen from the clock signal source 3, so that a parasitic capacitance deriving from the switches is reduced by 25%, and, a frequency at which dullness of the clock waveform is produced improves, so that the bandpass filter 1A can operate at a high frequency.

As described above, the bandpass filter 1A according to Embodiment 2 is controlled according to, for example, the clock signal S1, the clock signal S2, the clock signal S3, and the clock signal S4 whose phases differ by 90 degrees from each other in order and whose duty ratios are 50%.

The bandpass filter 1A includes the differential switch 4 that includes the switch 10 and the switch 11 connected to the input terminal 2A, the switch 11 being controlled according to the clock signal S1, and the switch 11 being controlled according to the clock signal S3, the differential switch 5A that includes the switch 12A and the switch 13A connected to the switch 10, the switch 12A being controlled according to the clock signal S4, and the switch 13A being controlled according to the clock signal S2, the differential switch 6A that includes the switch 14A and the switch 15A connected to the switch 11, the switch 14A being controlled according to the clock signal S2, and the switch 15A being controlled according to the clock signal S4, the differential switch 7A that includes the switch 16A connected to the switch 12A and controlled according to the clock signal S1, and the switch 17A connected to the switch 14A and controlled according to the clock signal S3, the differential switch 8A that includes the switch 18A connected to the switch 13A and controlled according to the clock signal S1, and the switch 19A connected to the switch 15A and controlled according to the clock signal S3, and the differential switch 9 that includes the capacitor 22A including the one end connected to a connection point between the switch 12A and the switch 16A, and the other end grounded, the capacitor 23A including the one end connected to a connection point between the switch 13A and the switch 18A, and the other end grounded, the capacitor 24A including the one end connected to a connection point between the switch 14A and the switch 17A, and the other end grounded, the capacitor 25A including the one end connected to a connection point between the switch 15A and the switch 19A, and the other end grounded, the switch 20 connected to the switch 16A and the switch 17A and controlled according to the clock signal S4, and the switch 21 connected to the switch 18A and the switch 19A and controlled according to the clock signal S2. An output signal output from the output terminal 2B is a signal obtained by synthesizing outputs of the switch 20 and the switch 21. With this configuration, the number of switches seen from the clock signal source 3 can be reduced by one, so that the bandpass filter 1A can suppress dullness of a clock signal deriving from a switch for switching a signal path.

Note that the embodiments can be combined with each other, any constituent elements in the embodiments can be modified, or any constituent elements in the embodiments can be omitted.

### INDUSTRIAL APPLICABILITY

A bandpass filter according to the present disclosure can be used for various wireless communication.

### REFERENCE SIGNS LIST

1, 1A: Bandpass filter, 2A: Input terminal, 2B: Output terminal, 3: Clock signal source, 4, 5, 5A, 6, 6A, 7, 7A, 8, 8A, 9: Differential switch, 10, 11, 12, 12A, 13, 13A, 14, 14A, 15, 15A, 16, 16A, 17, 17A, 18, 18A, 19, 19A, 20, 21: Switch, 22, 22A, 23, 23A, 23A, 24, 24A, 25, 25A: Capacitor

## Claims

1. A bandpass filter comprising:
an input terminal to receive an input of a high frequency signal;
an output terminal to output an output signal;
a plurality of differential switches provided between the input terminal and the output terminal, in which a plurality of switches respectively controlled according to clock signals is connected in a tournament pattern, each of the plurality of differential switches including two switches; and
a plurality of capacitors each including one end connected to a connection point between switches respectively included in differential switches among the plurality of differential switches, and another end grounded.

2. The bandpass filter according to claim 1, wherein
the plurality of differential switches includes
a first differential switch including a first switch and a second switch which are connected to the input terminal,
a second differential switch including a third switch and a fourth switch which are connected to the first witch,
a third differential switch including a fifth switch and a sixth switch which are connected to the second switch,
a fourth differential switch including a seventh switch connected to the third switch, and an eighth switch connected to the fourth switch,
a fifth differential switch including a ninth switch connected to the fifth switch, and a tenth switch connected to the sixth switch, and
a sixth differential switch including an eleventh switch connected to the seventh switch and the eighth switch, and a twelfth switch connected to the ninth switch and the tenth switch,
the plurality of capacitors includes
a first capacitor having one end connected to a connection point between the third switch and the seventh switch, and another end grounded,
a second capacitor having one end connected to a connection point between the fourth switch and the eighth switch, and another end grounded,
a third capacitor having one end connected to a connection point between the fifth switch and the ninth switch, and another end grounded, and
a fourth capacitor having one end connected to a connection point between the sixth switch and the tenth switch, and another end grounded, and
a signal obtained by synthesizing outputs of the eleventh switch and the twelfth switch is output from the output terminal.

3. The bandpass filter according to claim 1, wherein
the plurality of differential switches includes
a first differential switch including a first switch and a second switch which are connected to the input terminal,
a second differential switch including a third switch and a fourth switch which are connected to the first switch,
a third differential switch including a fifth switch and a sixth switch which are connected to the second switch,
a fourth differential switch including a seventh switch connected to the third switch, and an eighth switch connected to the fifth switch,
a fifth differential switch including a ninth switch connected to the fourth switch, and a tenth switch connected to the sixth switch, and
a sixth differential switch including an eleventh switch connected to the seventh switch and the eighth switch, and a twelfth switch connected to the ninth switch and the tenth switch,
the plurality of capacitors includes
a first capacitor having one end connected to a connection point between the third switch and the seventh switch, and another end grounded,
a second capacitor having one end connected to a connection point between the fourth switch and the ninth switch, and another end grounded,
a third capacitor having one end connected to a connection point between the fifth switch and the eighth switch, and another end grounded, and
a fourth capacitor having one end connected to a connection point between the sixth switch and the tenth switch, and another end grounded, and
a signal obtained by synthesizing outputs of the eleventh switch and the twelfth switch is output from the output terminal.

4. The bandpass filter according to any one of claims 1 to 3, wherein the clock signals have a phase that differs by 90 degrees from each other in order and have a duty ratio of 50%.
